# EUROPÄISCHE PATENTSCHRIFT

(11) **EP 1 606 872 B1**
(45) Veröffentlichungstag und Bekanntmachung des Hinweises auf die Patenterteilung: **16.04.2008**
(21) Anmeldenummer: 04718917.0
(22) Anmeldetag: 10.03.2004
(51) Int. Cl.: H02M 7/217, H02M 5/42

(54) **GASENTLADUNGSPROZESS-SPANNUNGSVERSORGUNGSEINHEIT**
POWER SUPPLY UNIT FOR A GAS DISCHARGE PROCESS
UNITE D'ALIMENTATION EN TENSION D'UN PROCEDE DE DECHARGE GAZEUSE

(30) Priorität: 21.03.2003 DE 10312549
(43) Veröffentlichungstag der Anmeldung: 21.12.2005
(73) Patentinhaber: HÜTTINGER Elektronik GmbH + Co. KG, 79111 Freiburg (DE)
(72) Erfinder: WIEDEMUTH, Peter, 79336 Herbolzheim (DE); SCHIRMAIER, Stefan, 79102 Freiburg (DE); WINTERHALTER, Markus, 79189 Bad Krozingen (DE)
(74) Vertreter: Schiz, Jochen
(86) Internationale Anmeldenummer: PCT/EP2004/002426
(87) Internationale Veröffentlichungsnummer: WO 2004/084394

(56) Entgegenhaltungen:
- DE-A- 3 830 460
- DE-A- 4 428 850
- DE-A- 19 627 497
- PATENT ABSTRACTS OF JAPAN Bd. 2002, Nr. 09, 4. September 2002 (2002-09-04) & JP 2002 153068 A (HITACHI LTD), 24. Mai 2002 (2002-05-24)
- PATENT ABSTRACTS OF JAPAN Bd. 0184, Nr. 93 (E-1606), 14. September 1994 (1994-09-14) & JP 6 165484 A (NIPPON MOTOROLA LTD), 10. Juni 1994 (1994-06-10)

## Beschreibung

### Stand der Technik

Die Erfindung betrifft ein Verfahren zur Erzeugung einer Ausgangsgleichspannung einer Gasentladungsprozess-Spannungsversorgungseinheit, bei dem in einer ersten Spannungswandelstufe eine erste Gleichspannung in eine zweite Gleichspannung eines vorgegebenen Spannungsbereichs gewandelt wird, und eine Vorrichtung zur Durchführung des Verfahrens.

Ein derartiges Verfahren und eine entsprechende Vorrichtung sind beispielsweise aus der DE 196 27 497 A1 bekannt. Die DE19522369 A1 zeigt eine Spannungsversorgung mit einem Hochsetsteller als erste Spannungswandlerstufe.

Gasentladungsprozesse besitzen auf Grund unterschiedlichster prozessseitiger Anforderungen, sowie anlagentechnischer Besonderheiten unterschiedliche Impedanzen. Dies bedeutet, dass für einen geforderten Leistungsumsatz unterschiedliche Entladungsspannungen bereit gestellt werden müssen. Außerdem ist zum zünden eines Gasentladungsprozesses häufig eine höhere Spannung notwendig, als zur Aufrechterhaltung des Gasentladungsprozesses.

Aus der DE 196 27 497 A1 ist ein Plasmagenerator mit einem Zündsteigerungsschaltkreis bekannt. Der Zündsteigerungsschaltkreis erzeugt eine hohe Spannung bei einer hohen Impedanz, um ein Plasma in einer Plasmakammer oder einer Sputterkammer zu initiieren. Der Zündsteigerungsschaltkreis ist parallel zu einer ersten Spannungswandelstufe des Plasmagenerators geschaltet und besitzt eine Vielzahl von Diodenbrücken, die als Vollwellengleichrichter wirken. Die Transformator-Sekundärseite der Energieversorgung ist über Isolationskondensatoren mit den Wechselstrom-(AC)-Eingängen jeder der Diodenbrücken verbunden. Die Gleistrom- (DC)-Anschlüsse der Diodenbrücken sind in Reihe geschaltet und die addierte Spannung wird über die Eingangsanschlüsse der Plasmakammer zugeführt. Jede Diodenbrücke besitzt auch einen Speicherkondensator, durch den positive und negative DC-Anschlüsse verbunden sind. Positive und negative Spannungs-Peaks von der Transformator-Sekundärseiten-Wellenform werden in den Speicherkondensatoren gespeichert. An den DC-Ausgänqen liegt eine Spannung, die hoch genug ist, um eine Plasmaentladung zu initiieren. Wenn das Plasma vorhanden ist, verhindert die Impedanz der Isolatianskondensatoren, dass der Zündsahaltkreis die hohe Zündspannung liefert. Die bekannte Vorrichtung und das zugehörige Verfahren sind nicht geeignet, die Gleichspannung am Ausgang des Plasmagenerators über einen weiten Spannungsbereich zu regeln.

Aus der DE 38 30 460 A1 sind mehrere Schaltungsanordnungen zur Speisung eines elektrischen Verbrauchers aus einem Wechselspannungsnetz bekannt. Diese Schaltungsanordnungen weisen Hochsetzsteller auf. Weiterhin ist erwähnt, dass mehrere Hochsetzsteller parallel betrieben werden können. Allerdings offenbart auch diese Druckschrift keine Serienschaltung von zwei Spannungswandelstufen, die jeweils eine Eingangsgleichspannung in eine Ausgangsgleichspannung wandeln.

Aus der DE 44 28 850 A1 ist eine Entladungslampenbeleuchtungseinrichtung bekannt geworden, die eine erste und eine zweite Spannungswandelstufe umfassen kann, wobei die beiden Spannungswandelstufen in Reihe geschaltet sind und jeweils eine Gleichspannung in eine Gleichspannung wandeln. Dabei weist die erste Spannungswandelstufe einen Hochsetzsteller auf; die zweite Spfnnungswandelstufe ist als Inverter ausgebildet.

### Aufgabe der Erfindung

Aufgabe der vorliegenden Erfindung ist es, ein Verfahren und eine Vorrichtung zur Durchführung des Verfahrens bereit zu stellen, so dass ein weiter Bereich von Ausgangsspannungen bei vorgegebener Nennausgangsleistung eingestellt werden kann.

### Gegenstand der Erfindung

Erfindungsgemäß wird diese Aufgabe dadurch gelöst, dass bei dem eingangs genannten Verfahren zur Erzeugung der Ausgangsgleichspannung die zweite Gleichspannung an eine zweite Spannungswandelstufe angelegt wird und in der zweiten Spannungswandelstufe die Ausgangsgleichspannung aus der zweiten Gleichspannung erzeugt wird, wobei in der zweiten Spannungswandelstufe ein schaltendes Element mindestens eines Hochsetzstellers mit einem geregelten Tastverhältnis geschaltet wird. Durch die erste Spannungswandelstufe wird eine erste Gleichspannung erzeugt, die insbesondere zum normalen Betrieb eines Gasentladungsprozesses, also insbesondere zur Aufrechterhaltung eines Gasentladungsprozesses, geeignet ist. Über die erste Spannungswandelstufe kann somit die Versorgungsspannung des Gasentladungsprozesses eingestellt werden. In der zweiten Spannungswandelstufe kann eine Erhöhung der Ausgangsspannung erfolgen, insbesondere zum Zünden des Gasentladungsprozesses. Nachdem der Gasentladungsprozess gezündet ist, kann über die zweite Spannungswandelstufe eine Regelung der Ausgangsspannung während der Aufrechterhaltung des Gasentladungsprozesses vorgenommen werden. Insbesondere kann durch die zweite Spannungswandelstufe eine Leistungseinstellung im oberen Ausgangsspannungsbereich erfolgen. Durch diese Maßnahme müssen nur die aktiven Elemente des Hochsetzstellers in Abhängigkeit von der maximal zulässigen Ausgangsspannung gewählt werden. Die Bauelemente der ersten Spannungswandelstufe sind davon unabhängig. Das Schalten des schaltenden Elements des Hochsetzstellers mit einem geregelten Tastverhältnis hat den Vorteil, dass der Hochsetzsteller leerlauffest ist. Es kann damit verhindert werden, dass mit jedem Takt Energie von der Induktivität in den Siebkondensator des Hochsetzstellers gepumpt wird. Ein Ansteigen der Ausgangsgleichspannung im Leerlauf, die zu einer Zerstörung der Bauelemente führen kann, wird dadurch vermieden. Außerdem kann durch die Regelung des Tastverhältnisses die Ausgangsgleichspannung eingestellt werden. Insbesondere kann das Tastverhältnis auf Null gesetzt werden, so dass die Ausgangsgleichspannung der der zweiten Gleichspannung entspricht.

Bei einer besonders bevorzugten Verfahrensvariante wird die zweite Gleichspannung in der zweiten Stromwandelstufe erhöht. Durch die Erhöhung der zweiten Gleichspannung ist es insbesondere möglich, den Gasentladungsprozess zu zünden, ohne dass zusätzliche Zündsteigerungsschaltkreise notwendig sind.

Bei einer Verfahrensvariante kann vorgesehen sein, dass die Ausgangsgleichspannung aus der zweiten Gleichspannung erzeugt wird, indem die schaltenden Elemente von mindestens zwei Hochsetzstellern mit einem geregelten Tastverhältnis zeitlich versetzt geschaltet werden. Dies hat den Vorteil, dass die schaltenden Elemente bei niedrigeren Frequenzen betrieben werden können und ermöglicht ein optimales Arbeiten der schaltenden Elemente. Außerdem kann ein Siebkondensator am Ausgang der zweiten Spannungswandelstufe mit kleinerer Kapazität ausgebildet werden. Daher kann ein schnelles Abschalten der Spannungsversorgungseinheit erfolgen. Ein schnelles Abschalten ist insbesondere dann erforderlich, wenn sogenannte Arcs im Plasmaprozess auftreten. Diese Arcs führen zu Instabilitäten im Plasmaprozess und können die Kathode oder andere Elemente in der Plasmakammer zerstören. Wenn ein solcher Arc auftritt, muss daher die Spannungsversorgung schnell abgeschaltet werden. Nach dem Abschalten verbleibt nur eine geringe Restenergie im Gesamtsystem, nämlich der Stromversorgung und der Plasmaanlage. Als weiterer Vorteil ist zu nennen, dass durch die Verwendung zweier Hochsetzsteller, die mit einem geregelten Tastverhältnis zeitlich versetzt schalten, eine glatte (weitestgehend ripplefreie) Gleichspannung am Ausgang der Spannungsversorgungseinheit erzeugt werden kann.

Das Erzeugen einer Ausgangsgleichspannung aus einer Eingangsgleichspannung, indem die schaltenden Elemente von mindestens zwei Hochsetzstellern mit einem geregelten Tastverhältnis zeitlich versetzt geschaltet werden, stellt eine eigenständige Erfindung dar, die unabhängig ist, von der Art und Weise, wie die Eingangsgleichspannung erzeugt wird. Besonders vorteilhaft ist es, wenn die Hochsetzsteller parallel geschaltet sind und die Eingangsgleichspannung zu einer Ausgangsgleichspannung erhöht wird.

Besonders vorteilhaft wird das schaltende Element mit einer Frequenz ≥ 18 kHz angesteuert, da bei diesen Frequenzen Schwingungen, die beispielsweise in Übertragern angeregt werden, nicht im hörbaren Bereich liegen. Außerdem können passive Bauelemente, wie z.B. Übertrager, kleiner ausgelegt werden.

Vorzugsweise werden die schaltenden Elemente mit derselben Frequenz oder mit einem Vielfachen einer vorgegebenen Grundfrequenz angesteuert. Durch diese Maßnahme werden Schwebungen verhindert. Schwebungen könnten z.B. auftreten, wenn die schaltenden Elemente mit unterschiedlichen Ansteuerfrequenzen angesteuert werden. Dies wäre beispielsweise bei einer frequenzverändernden Regelung der Fall. Die Ansteuerung der schaltenden Elemente mit derselben Frequenz oder einem Vielfachen einer vorgegebenen Grundfrequenz hat eine verbesserte elektromagnetische Verträglichkeit (EMV) zur Folge. Eine gegenseitige Beeinflussung der schaltenden Elemente und eine Beeinflussung von anderen Baugruppen oder Fremdgeräten wird somit weitestgehend unterbunden.

Bei einer bevorzugten Verfahrensvariante wird die erste Gleichspannung zunächst in eine Wechselspannung gewandelt, die anschließend in die zweite Gleichspannung gleichgerichtet wird. Durch diese Maßnahme ist die Eingangsspannung der zweiten Stromwandelstufe einstellbar. Außerdem kann innerhalb der ersten Stromwandelstufe eine Potentialtrennung zwischen dem Eingang und dem Ausgang der ersten Stromwandelstufe vorgenommen werden. Die Amplitude der Wechselspannung ist einstellbar. Außerdem ist die Wellenform der Wechselspannung einstellbar.

Bei einer bevorzugten Weiterbildung des Verfahrens wird die Wechselspannung durch eine Brückenschaltung schaltender Elemente erzeugt, wobei die schaltenden Elemente pulsweitenmoduliert oder phasenverschoben angesteuert werden können. Durch diese Maßnahme kann zum einen eine Leistungseinstellung für niedrige Lastspannungen erfolgen. Zum anderen kann die Eingangsspannung der ersten Spannungswandelstufe transformiert werden. Weiterhin ist die Wellenform der Wechselspannung frei einstellbar. Die Brückenschaltung kann als Halbbrücke oder als Vollbrücke ausgebildet sein.

Besonders bevorzugt ist es, wenn die schaltenden Elemente der Brückenschaltung und die schaltenden Elemente des oder der Hochsetzsteller mit derselben Frequenz oder mit einem Vielfachen einer vorgegebenen Grundfrequenz angesteuert werden. Ein Schwebungsverhalten wird durch diese Maßnahme unterbunden. Die gemeinsame Steuerung der schaltenden Elemente wirkt sich positiv auf die elektromagnetische Verträglichkeit aus. Die erste und zweite Spannungswandelstufe beeinflussen sich gegenseitig nicht.

Besonders vorteilhaft ist es, wenn die Wechselspannung vor der Gleichrichtung transformiert wird. Durch die Transformation kann eine Potentialtrennung vorgenommen werden. Außerdem lässt sich die Eingangsspannung der zweiten Spannungswandelstufe und, wenn keine Spannungserhöhung in der zweiten Spannungswandelstufe erfolgt, die Ausgangsspannung der Spannungsversorgungseinheit einstellen.

Vorzugsweise wird die erste Gleichspannung aus einer Netzspannung durch Gleichrichten erzeugt. Dies hat den Vorteil, dass die gesamte Spannungsversorgungsanordnung an nahezu beliebigen Netzspannungen betrieben werden kann. Mit ein und derselben Spannungsversorgungsanordnung können Plasmaanlagen an verschiedensten Netzspannungen und für verschiedenste Ausgangsgleichspannungen betrieben werden.

Besonders vorteilhaft ist es, wenn aus der ersten Gleichspannung die zweite Gleichspannung mit einer Spannung < 650 V, vorzugsweise im Bereich von 50 - 650 V erzeugt wird und aus der zweiten Gleichspannung die Ausgangsgleichspannung mit eine Spannung > 600 V, vorzugsweise im Bereich 600 - 2000 V erzeugt wird. Dabei wird durch die erste Spannungswandelstufe eine relativ niedrige Ausgangsgleichspannung, insbesondere zum Aufrechterhalten eines Gasentladungsprozesses, bzw. bei niedriger Lastimpedanz und hohem Ausgangsstrom erzeugt und in der zweiten Spannungswandelstufe wird eine höhere Ausgangsspannung erzeugt, insbesondere zum Zünden eines Gasentladungsprozesses oder zur Leistungseinstellung im oberen Ausgangsspannungsbereich, d.h. bei hoher Lastimpedanz und demzufolge hoher Ausgangsgleichspannung. Wenn daher in der ersten Spannungswandelstufe eine kleine und in der zweiten Spannungswandelstufe eine große Spannung erzeugt wird, müssen nur für die zweite Spannungswandelstufe solche Bauelemente verwendet werden, die für hohe Spannungen ausgelegt sind. Der Sicherheitsabstand zwischen den Elementen der ersten Spannungswandelstufe kann geringer gewählt werden, da geringere Spannungen auftreten.

Erfindungsgemäß wird die Aufgabe außerdem gelöst durch eine Plasmaprozess-Gleichspannungsversorgungseinheit mit den Merkmalen des Patentanspruchs 13. Eine solche Gleichspannungsversorgungseinheit ist über einen weiten Eingangsspannungsbereich und geforderten Ausgangsgleichspannungsbereich einsetzbar. Die erste Spannungswandelstufe kann ein beliebiger DC/DC-Konverter sein, z.B. ein Tiefsetzsteller, ein Hochsetzsteller oder eine Kombination derselben. In der ersten Spannungswandelstufe kann die erste Gleichspannung erhöht oder erniedrigt werden.

Vorzugsweise ist eine Steuereinheit vorgesehen die die erste und zweite Spannungswandelstufe ansteuert. Die gemeinsame Steuerung der ersten und zweiten Spannungswandelstufe durch die Steuereinheit in Verbindung mit der Verwendung eines Hochsetzstellers in der zweiten Spannungswandelstufe ermöglicht zum einen das zuverlässige Zünden eines Gasentladungsprozesses und zum anderen die kontinuierliche Einstellung der Ausgangsgleichspannung auf die Plasmaprozesserfordernisse. Es ist auch denkbar, für jede Spannungswandelstufe jeweils eine eigene Steuereinheit vorzusehen.

Bei einer bevorzugten Ausführungsform sind in der zweiten Spannungswandelstufe mindestens zwei parallel geschaltete Hochsetzsteller vorgesehen. Durch diese Maßnahme können die Bauelemente in der zweiten Spannungswandelstufe geschont werden. Insbesondere können die schaltenden Elemente im Vergleich zur Verwendung nur eines Hochsetzstellers bei einer niedrigeren Frequenz betrieben werden. Die zweite Spannungswandelstufe, die mindestens zwei parallel geschaltete Hochsetzsteller aufweist, kann auch eigenständig alls erfindungsgemäße Plasmaprozess-Gleichspannungsversorgungseinheit betrachtet werden. Die Hochsetzsteller können an eine gemeinsame Gleichspannungsversorgung angeschlossen sein oder jeder Hochsetzsteller kann eine eigene Gleichspannungsversorgung aufweisen.

Besonders bevorzugt ist es, wenn die Hochsetzsteller einen gemeinsamen Siebkondensator aufweisen. Für eine vorgegebene maximale Ausgangsgleichspannung können Siebkondensatoren mit sehr geringer Kapazität verwendet werden. Dies ermöglicht eine schnelle Entladung des Kondensators und damit einen Schutz vor Zerstörung der Plasmaprozess-Gleichspannungsversorgungseinheit. Außerdem werden durch diese Maßnahme die Elemente des Plasmaprozesses, wie Substrat und Targets, geschützt.

Relativ kostengünstige schaltende Elemente, insbesondere Transistoren, können eingesetzt werden, wenn die schaltenden Elemente der Hochsetzsteller zeitlich versetzt angesteuert sind. Dadurch, dass die schaltenden Elemente zeitlich versetzt angesteuert werden, können die einzelnen schaltenden Elemente bei einer geringeren Frequenz betrieben werden.

Bei einer bevorzugten Ausführungsform weist die erste Spannungswandelstufe einen, insbesondere von der Steuereinheit angesteuerten, Wechselrichter zum Erzeugen einer Wechselspannung aus der ersten Gleichspannung, einen damit verbundenen Übertrager zur Spannungstransformation der Wechselspannung und einen Gleichrichter zum Erzeugen der zweiten Gleichspannung auf. Diese Vorrichtung erlaubt eine Einstellung der Ausgangsgleichspannung für niedrige Ausgangsgleichspannungen. Die Verwendung des Übertragers ermöglicht eine für Plasmaprozess häufig geforderte Potentialtrennung zwischen der Spannung am Eingang und Ausgang der Stromversorgungseinheit, also insbesondere zwischen der netzseitigen Spannung und der Spannung des Plasmaprozesses.

Bei einer bevorzugten Weiterbildung ist der Wechselrichter als Brückenschaltung ausgebildet. Diese Maßnahme erlaubt es, auf die Amplitude und Wellenform der im Wechselrichter erzeugten Wechselspannung Einfluss zu nehmen. Durch entsprechende Ansteuerung der schaltenden Elemente der Brückenschaltung kann die Amplitude der Eingangsgleichspannung verringert werden. Durch die Ansteuerfrequenz und das Tastverhältnis, mit dem die schaltenden Elemente angesteuert werden, kann die Wellenform der erzeugten Wechselspannung beeinflusst werden. Diese Maßnahme erlaubt es, die Ausgangswechselspannung so einzustellen, dass die Dimensionen des Übertragers in der ersten Spannungswandelstufe klein gehalten werden können. Insbesondere, wenn eine hochfrequente Wechselspannung generiert wird, beispielsweise im Bereich 10 - 100 kHz, kann der Übertrager klein dimensioniert werden. Außerdem kann der Wirkungsgrad der gesamten Anordnung verbessert werden. Alternativ kann die erste Gleichspannung erhöht werden, indem durch die Brückenschaltung ein Schwingkreis angesteuert wird.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

### Zeichnung

Ein Ausführungsbeispiel der erfindungsgemäßen Gasentladungsprozess-Spannungsversorgungseinheit ist in der schematischen Zeichnung dargestellt und wird in der nachfolgenden Beschreibung erläutert. Es zeigt:
- **Fig. 1**: eine erste schaltbildmäßige Darstellung einer Plasmaprozess-Gleichspannungsversorgungseinheit;
- **Fig. 2**: eine zweite Ausführungsform einer Plasmaprozess-Gleichspannungsversorgungseinheit.

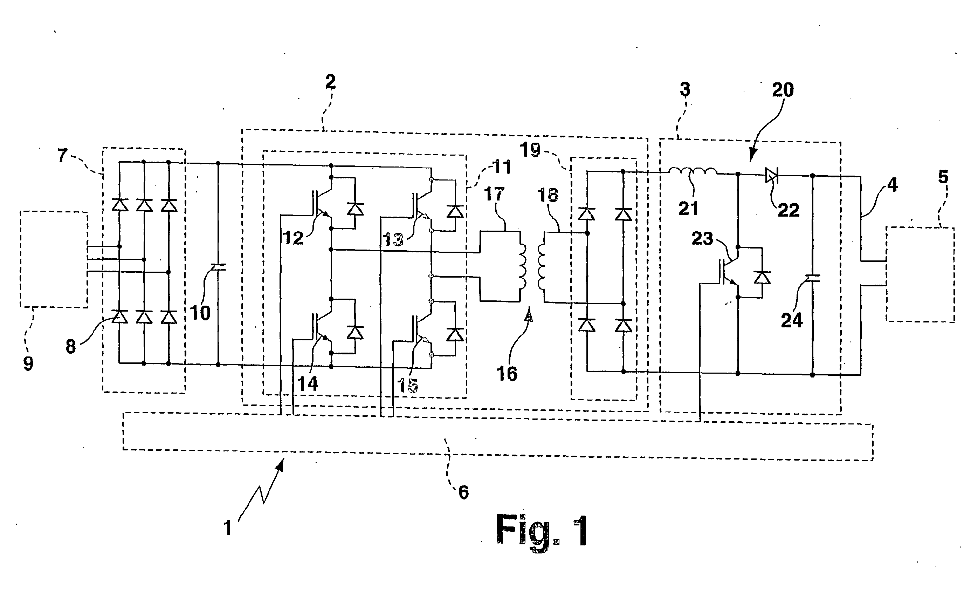

**Fig. 1** zeigt eine Plasmaprozess-Gleichspannungsversorgungseinheit **1** mit einer ersten Spannungswandelstufe **2** und einer damit verbundenen zweiten Spannungswandelstufe **3.** Am Ausgang **4** der zweiten Spannungswandelstufe 3 ist eine Last **5,** insbesondere ein Gasentladungs- oder Plasmaprozess angeschlossen. Die erste Spannungswandelstufe 2 und zweite Spannungswandelstufe 3 werden durch eine gemeinsame Steuereinheit **6** angesteuert. Der ersten Spannungswandelstufe 2 wird eine erste Gleichspannung zugeführt. Die erste Gleichspannung wird im Ausführungsbeispiel durch einen Gleichrichter **7,** der mehrere Dioden 8 enthält, aus einer Netzspannung eines Netzanschlusses **9** erzeugt. Zwischen den Gleichrichter 7 und die erste Spannungswandelstufe 2 ist ein Zwischenkreiskondensator **10** geschaltet, der der Energiespeicherung dient.

In der ersten Spannungswandelstufe 2 wird die Eingangsgleichspannung durch einen Wechselrichter **11** in eine Wechselspannung gewandelt. Der Wechselrichter 11 weist eine aus schaltenden Elementen **12 bis 15** gebildete Brückenschaltung auf, wobei die schaltenden Elemente 12 bis 15 als Transistoren ausgebildet sind und von der Steuereinheit 6 angesteuert werden. Durch geeignete Ansteuerung der schaltenden Elemente 12 bis 15 kann am Ausgang des Wechselrichters 11 eine Wechselspannung erzeugt werden, wobei im Ausführungsbeispiel die Amplitude der Wechselspannung maximal der am Eingang anliegenden ersten Gleichspannung entspricht. Die Amplitude kann jedoch durch Ansteuerung der schaltenden Elemente 12 bis 15 reduziert werden. Die Ansteuerung kann z.B. nach dem PWM- (Pulsweitenmodulation) oder Phase-Shift-Verfahren erfolgen. Bei beiden Verfahren wird mit einer festen Frequenz f und damit einer festen Periodendauer T=1/f gearbeitet. Um einen Kurzschluss zu vermeiden, müssen die schaltenden Elemente 13, 14 ausgeschaltet sein, wenn die schaltenden Elemente 12, 15 eingeschaltet sind und umgekehrt. Die maximale Einschaltdauer bei symmetrischer Ansteuerung ist damit auf T/2 begrenzt. Beim PWM-Verfahren werden die diagonal angeordneten schaltenden Elemente 12, 15 gleichzeitig ein- und ausgeschaltet und auch die diagonal angeordneten schaltenden Elemente 13, 14 gleichzeitig ein- und ausgeschaltet. Die Einschaltdauer wird jeweils zwischen 0 und T/2 geregelt. Beim Phase-Shift-Verfahren liegt die Einschaltdauer immer bei T/2. Die untereinander angeordneten schaltenden Elemente 12, 14 werden genau T/2 versetzt ein- bzw. ausgeschaltet, genauso die schaltenden Elemente 13, 15. Zur Regelung wird der Einschaltzeitpunkt des schaltenden Elements 13 gegenüber dem Einschaltzeitpunkt des schaltenden Elements 12 verschoben, wobei die Verschiebung zwischen 0 und T/2 liegt. Dies bedeutet, dass die Phasenlage verschoben wird.

Auch die Wellenform der Wechselspannung kann durch die Brückenschaltung beeinflusst werden. Die Wechselspannung am Ausgang des Wechselrichters 11 liegt an einem Übertrager **16** an, der im Ausführungsbeispiel eine galvanische Trennung durchführt. Im Ausführungsbeispiel entspricht die Wicklungszahl auf der Primärseite **17** der Wicklungszahl auf der Sekundärseite 18, so dass keine Spannungstransformation vorgenommen wird. Es ist jedoch auch denkbar, durch den Übertrager 16 die primärseitige Wechselspannung auf einen höheren oder niedrigeren Wert zu transformieren. Die sekundärseitige Wechselspannung am Übertrager 16 wird durch einen Gleichrichter **19** in eine zweite Gleichspannung umgewandelt. Am Ausgang der ersten Spannungswandelstufe 2 ist eine relativ geringe Ausgangsspannung erwünscht, die beispielsweise mit 650 V vorgegeben sein kann. Würde eine höhere zweite Gleichspannung gefordert, müssten die Dioden des Gleichrichters 19 und die schaltenden Elemente 12 - 15 dafür ausgelegt sein. Solche Bauelemente sind relativ teuer und bringen andere Nachteile mit sich. Bei einer geringeren vorgegebenen ersten Gleichspannung können die Bauelemente der ersten Spannungswandelstufe kleiner dimensioniert werden. Außerdem sind die Anforderungen an die Durchschlagfestigkeit und Kriechstromfestigkeit der Isolatoren geringer. Interne Überschläge können leichter vermieden werden. Der Sicherheitsabstand zwischen den Bauelementen kann geringer sein. Daraus ergibt sich eine insgesamt kompaktere Bauweise. Nur die Bauelemente der zweiten Stromwandelstufe 3 müssen für höhere Spannungen, die insbesondere zum Zünden eines Plasmaprozesses benötigt werden, ausgelegt sein.

Die zweite Gleichspannung am Ausgang der ersten Spannungswandelstufe 2 liegt am Eingang der zweiten Spannungswandelstufe 3 an. Die zweite Spannungswandelstufe 3 weist einen Hochsetzsteller **20** auf, der eine Spule **21,** eine Diode **22,** ein schaltendes Element **23** und einen Siebkondensator **24** umfasst. Je nach Beschaltung des schaltenden Elements 23 durch die Steuereinheit 6 wird die Eingangsgleichspannung entweder bis zur Last 5 durchgeschaltet oder in eine höhere Spannung transformiert. Während der Einschaltphase des schaltenden Elements 23 fällt die Eingangsspannung an der Induktivität 21 ab. Der Strom durch die Induktivität 21 steigt linear an. Schaltet das schaltende Element 23 ab, so fließt der Strom über die Diode 22 weiter und lädt den Siebkondensator 24 auf. Dies bedeutet, dass während der Einschaltphase Energie in die Induktivität 21 geladen wird. Diese wird während der Sperrphase des schaltenden Elements 23 an den Siebkondensator 24 übertragen. Wird das als Transistor ausgebildete schaltende Element 23 nicht getaktet, d.h. mit einem bestimmten Tastverhältnis angesteuert, so wird der Siebkondenstor 24 über die Induktivität 21 und die Diode 22 auf die zweite Gleichspannung geladen. Wird das schaltende Element 23 getaktet, so steigt die Ausgangsspannung am Ausgang 4 auf Werte, die höher sind als die zweite Gleichspannung. Die Ausgangsspannung am Ausgang 4 ist im kontinuierlichen Betrieb nur vom Tastverhältnis und der zweiten Gleichspannung, d.h. der Eingangsspannung der zweiten Spannungswandelstufe 3 abhängig. Die Ausgangsspannung ist lastunabhängig.

Das Tastverhältnis des schaltenden Elements 23 ist geregelt, da im nichtgeregelten Betrieb, insbesondere bei Ansteuerung mit einem festen Tastverhältnis der Hochsetzsteller 20 nicht leerlauffest ist. Mit jedem Takt wird Energie von der Induktivität 21 in den Siebkondensator 24 gepumpt. Im Leerlauf steigt die Ausgangsspannung daher kontinuierlich an, bis Bauelemente zerstört werden. Das Tastverhältnis wird durch die Steuereinheit 6 eingestellt.

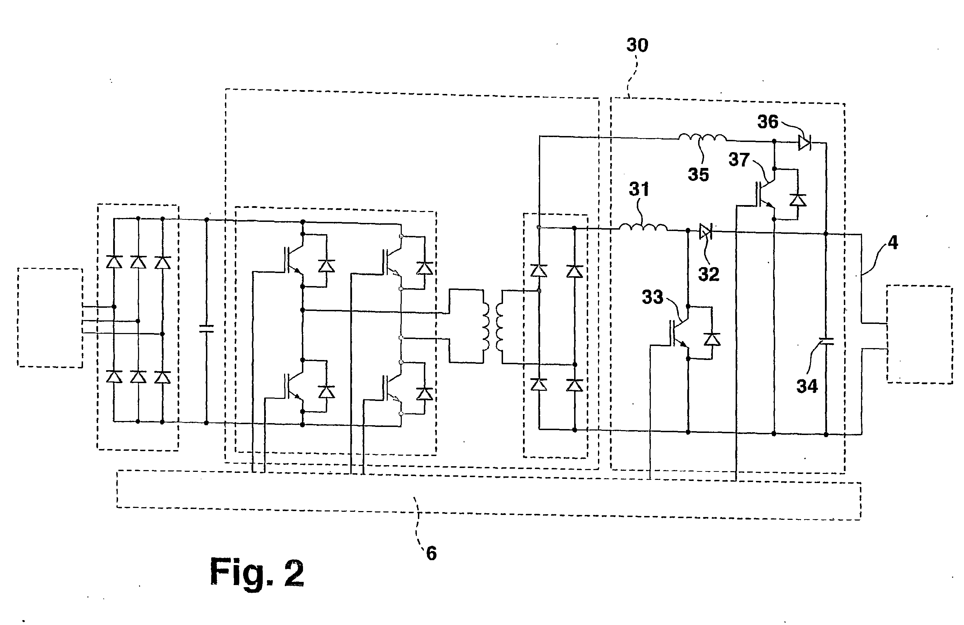

Im Ausführungsbeispiel der **Fig. 2** weist die zweite Spannungswandelstufe **30** zwei parallel geschaltete Hochsetzsteller auf. Der erste Hochsetzsteller umfasst die Induktivität **31,** die Diode **32,** das schaltende Element **33** und den Siebkondensator **34.** Der zweite, dazu parallel geschaltete Hochsetzsteller umfasst die Induktivität **35,** die Diode **36,** das schaltende Element **37** und ebenfalls den Siebkondensator 34. Die beiden Hochsetzsteller weisen also einen gemeinsamen Siebkondensator 34 auf. Die schaltenden Elemente 33, 37 werden von der Steuereinrichtung 6 zeitlich versetzt mit einem geregelten Tastverhältnis angesteuert. Die zeitlich versetzte Ansteuerung bewirkt, dass jedes schaltende Element 33, 37 bei einer relativ niedrigen Frequenz betrieben werden kann. Abwechselnd wird durch die beiden Hochsetzsteller dem Siebkondensator 34 Energie zugeführt und damit die Ausgangsspannung erzeugt. Diese Betriebsweise ist besonders bauteilschonend und es können relativ kostengünstige, kommerziell erhältliche Bauelemente verwendet werden. Durch geeignete Ansteuerung der schaltenden Elemente 33, 37 kann auch die Eingangsgleichspannung der zweiten Spannungwandelstufe 30 an den Ausgang 4 durchgeschaltet werden.

Bei einem Verfahren zur Erzeugung einer Ausgangsgleichspannung einer Gasentladungsprozess-Spannungsversorgungseinheit 1, bei dem in einer ersten Spannungswandelstufe 2 eine erste Gleichspannung in eine zweite Gleichspannung eines vorgegebenen Spannungsbereichs gewandelt wird und in einer zweiten Spannungswandelstufe 3 die Ausgangsgleichspannung aus der zweiten Gleichspannung erzeugt wird, wird zur Erzeugung der Ausgangsgleichspannung in der, zweiten Spannungswandelstufe ein schaltendes Element 23 mindestens eines Hochsetzstellers 20 mit einem geregelten Tastverhältnis geschaltet. Dieses Verfahren ermöglicht das Zünden des Plasmaprozesses und die Aufrechterhaltung des Plasmaprozesses.

## Patentansprüche

1. Verfahren zur Erzeugung einer Ausgangsgleichspannung einer Gasentladungsprozess-Spannungsversorgungseinheit (1), bei dem in einer ersten Spannungswandelstufe (2) eine erste Gleichspannung in eine zweite Gleichspannung eines vorgegebenen Spannungsbereichs gewandelt wird, wobei zur Erzeugung der Ausgangsgleichspannung die zweite Gleichspannung an eine zweite Spannungswandelstufe (3) angelegt wird und in der zweiten Spannungswandelstufe (3) die Ausgangsgleichspannung aus der zweiten Gleichspannung erzeugt wird, wobei in der zweiten Spannungswandelstufe ein schaltendes Element (23) mindestens eines Hochsetzstellers (20) mit einem geregelten Tastverhältnis geschaltet wird.

2. Verfahren nach Anspruch 1, **dadurch gekennzeichnet, dass** die zweite Gleichspannung in der zweiten Spannungswandelstufe (3) erhöht wird.

3. Verfahren nach Anspruch 2, **dadurch gekennzeichnet, dass** die Ausgangsgleichspannung aus der zweiten Gleichspannung erzeugt wird, indem die schaltenden Elemente (33, 37) von mindestens zwei Hochsetzstellern mit einem geregelten Tastverhältnis zeitlich versetzt geschaltet werden.

4. Verfahren zur Erzeugung einer Ausgangsgleichspannung einer Gasentladungsprozess-Spannungsversorgungseinheit, bei dem aus einer Gleichspannung durch mindestens zwei, insbesondere parallel geschaltete, Hochsetzsteller eine, insbesondere höhere, Gleichspannung erzeugt wird, indem die schaltenden Elemente (33, 37) der Hochsetzsteller mit einem geregelten Tastverhältnis zeitlich versetzt geschaltet werden.

5. Verfahren nach einem der vorhergehenden Ansprüche, **dadurch gekennzeichnet, dass** das schaltende Element mit einer Frequenz ≥ 18 kHz angesteuert wird.

6. Verfahren nach einem der Ansprüche 3 bis 5, **dadurch gekennzeichnet, dass** die schaltenden Elemente (33, 37) mit derselben Frequenz oder mit einem Vielfachen einer vorgegebenen Grundfrequenz angesteuert werden.

7. Verfahren nach einem der Ansprüche 1 bis 3 oder 5, 6, **dadurch gekennzeichnet, dass** die erste Gleichspannung zunächst in eine Wechselspannung gewandelt wird, die anschließend in die zweite Gleichspannung gleichgerichtet wird.

8. Verfahren nach Anspruch 7, **dadurch gekennzeichnet, dass** die Wechselspannung durch eine Brückenschaltung schaltender Elemente (12 - 15) erzeugt wird, wobei die schaltenden Elemente (12 - 15) pulsweitenmoduliert oder phasenverschoben (Phase Shift) angesteuert werden.

9. Verfahren nach Anspruch 8, **dadurch gekennzeichnet, dass** die schaltenden Elemente (12 - 15) der Brückenschaltung und die schaltenden Elemente (23, 33, 37) des oder der Hochsetzsteller (20) mit derselben Frequenz oder mit einem Vielfachen einer vorgegebenen Grundfrequenz angesteuert werden.

10. Verfahren nach Anspruch 8 oder 9, **dadurch gekennzeichnet, dass** die Wechselspannung vor der Gleichrichtung transformiert wird.

11. Verfahren nach einem der vorhergehenden Ansprüche, **dadurch gekennzeichnet, dass** die erste Gleichspannung aus einer Netzspannung durch Gleichrichten erzeugt wird.

12. Verfahren nach einem der vorhergehenden Ansprüche, **dadurch gekennzeichnet, dass** aus der ersten Gleichspannung die zweite Gleichspannung mit einer Spannung < 650 V, vorzugsweise im Bereich 50 - 650 V, erzeugt wird und aus der zweiten Gleichspannung die Ausgangsspannung mit einer Spannung > 600 V, vorzugsweise im Bereich 600 - 2000 V, erzeugt wird.

13. Plasmaprozess-Gleichspannungsversorgungseinheit (1) zur Durchführung des Verfahrens nach einem der Ansprüche 1 bis 12, mit einer ersten Spannungswandelstufe (2) zum Wandeln einer ersten Gleichspannung in eine zweite Gleichspannung und einer zweiten Spannungswandelstufe (3), wobei die zweite Spannungswandelstufe (3) zum Wandeln der zweiten Gleichspannung in eine Ausgangsgleichspannung auf die erste Spannungswandelstufe (2) folgt und zur Erzeugung der Ausgangsspannung mindestens einen Hochsetzsteller (20) mit einem schaltenden Element (23) aufweist, das mit einem geregelten Tastverhältnis angesteuert ist.

14. Plasmaprozess-Gleichspannungsversorgungseinheit nach Anspruch 13, **dadurch gekennzeichnet, dass** eine Steuereinheit (6) vorgesehen ist, die die erste und zweite Spannungswandelstufe (2, 3) ansteuert.

15. Plasmaprozess-Gleichspannungsversorgungseinheit, insbesondere nach Anspruch 13 oder 14, **dadurch gekennzeichnet, dass** mindestens zwei parallel geschaltete Hochsetzsteller vorgesehen sind.

16. Plasmaprozess-Gleichspannungsversorgungseinheit nach Anspruch 15, **dadurch gekennzeichnet, dass** die Hochsetzsteller einen gemeinsamen Siebkondensator (34) aufweisen.

17. Plasmaprozess-Gleichspannungsversorgungseinheit nach einem der Ansprüche 15 oder 16, **dadurch gekennzeichnet, dass** die schaltenden Elemente (33, 37) der Hochsetzsteller zeitlich versetzt angesteuert sind.

18. Plasmaprozess-Gleichspannungsversorgungseinheit nach einem der vorhergehenden Ansprüche 13 - 17 **dadurch gekennzeichnet, dass** die erste Spannungswandelstufe (2) einen Wechselrichter (11) zum Erzeugen einer Wechselspannung aus der ersten Gleichspannung, einen damit verbundenen Übertrager (16) zur Spannungstransformation der Wechselspannung und einen Gleichrichter (19) zum Erzeugen der zweiten Gleichspannung aufweist.

19. Plasmaprozess-Gleichspannungsversorgungseinheit nach Anspruch 18, **dadurch gekennzeichnet, dass** der Wechselrichter (11) als Brückenschaltung ausgebildet ist.

## Claims

1. Method for generating an output DC voltage of a gas discharge process voltage supply unit (1), wherein in a first voltage transformation stage (2), a first DC voltage is transformed into a second DC voltage of a predetermined voltage range, wherein for generating the output DC voltage, the second DC voltage is applied to a second voltage transformation stage (3), and in the second voltage transformation stage (3), the output DC voltage is generated from the second DC voltage, wherein a switching element (23) of at least one boost converter (20) is switched with a controlled pulse-duty factor in the second voltage transformation stage.

2. Method according to claim 1, **characterized in that** the second DC voltage is increased in the second voltage transformation stage (3).

3. Method according to claim 2, **characterized in that** the output DC voltage is generated from the second DC voltage by switching the switching elements (33, 37) of at least two boost converters with a controlled pulse-duty factor in a temporally offset manner.

4. Method for generating an output DC voltage of a gas discharge process voltage supply unit, wherein an, in particular higher, DC voltage is generated from a DC voltage by at least two, in particular parallel, boost converters by switching the switching elements (33, 37) of the boost converters with a controlled pulse-duty factor in a temporally offset manner.

5. Method according to any one of the preceding claims, **characterized in that** the switching element is driven by a frequency ≥ 18kHz.

6. Method according to any one of the claims 3 through 5, **characterized in that** the switching elements (33, 37) are driven at the same frequency or a multiple of a predetermined basic frequency.

7. Method according to any one of the claims 1 through 3 or 5, 6, **characterized in that** the first DC voltage is initially transformed into an AC voltage which is subsequently rectified into the second DC voltage.

8. Method according to claim 7, **characterized in that** the AC voltage is generated by a bridge circuit of switching elements (12-15), wherein the switching elements (12-15) are driven in a pulse-width modulated or phase-shifted manner.

9. Method according to claim 8, **characterized in that** the switching elements (12-15) of the bridge circuit and the switching elements (23, 33, 37) of the boost converter(s) (20) are driven at the same frequency or at a multiple of a predetermined basic frequency.

10. Method according to claim 8 or 9, **characterized in that** the AC voltage is transformed before rectification.

11. Method according to any one of the preceding claims, **characterized in that** the first DC voltage is generated from a mains voltage through rectification.

12. Method according to any one of the preceding claims, **characterized in that** the second DC voltage of a voltage < 650 V, preferably in the range between 50 and 650 V, is generated from the first DC voltage, and the output voltage of a voltage > 600 V, preferably in the range between 600 and 2000 V, is generated from the second DC voltage.

13. Plasma process DC voltage supply unit (1) for carrying out the method according to any one of the claims 1 through 12, comprising a first voltage transformation stage (2) for transforming a first DC voltage into a second DC voltage, and a second voltage transformation stage (3), wherein the second voltage transformation stage (3) for transforming the second DC voltage into an output DC voltage follows the first voltage transformation stage (2) and comprises at least one boost converter (20) with a switching element (23) which is driven with a controlled pulse-duty factor for generating the output voltage.

14. Plasma process DC voltage supply unit according to claim 13, **characterized in that** a control unit (6) is provided which controls the first and second voltage transformation stages (2, 3).

15. Plasma process DC voltage supply unit, in particular, according to claim 13 or 14, **characterized in that** at least two boost converters are provided which are connected in parallel.

16. Plasma process DC voltage supply unit according to claim 15, **characterized in that** the boost converters comprise a common filter capacitor (34).

17. Plasma process DC voltage supply unit according to any one of the claims 15 or 16, **characterized in that** the switching elements (33, 37) of the boost converters are driven in a temporally offset manner.

18. Plasma process DC voltage supply unit according to any one of the preceding claims 13 through 17, **characterized in that** the first voltage transformation stage (2) comprises an inverter (11) for generating an AC voltage from the first DC voltage, a transformer (16) connected thereto, for voltage transformation of the AC voltage, and a rectifier (19) for generating the second DC voltage.

19. Plasma process DC voltage supply unit according to claim 18, **characterized in that** the inverter (11) is embodied as a bridge circuit.

## Revendications

1. Procédé pour générer une tension continue de sortie d'une unité d'alimentation en tension d'un processus à décharge gazeuse (1), dans lequel, dans un premier étage de conversion de tension (2), une première tension continue est convertie en une deuxième tension continue d'une plage de tension prédéfinie, la deuxième tension continue étant appliquée à un deuxième étage de conversion de tension (3) pour générer la tension continue de sortie, et, dans le deuxième étage de conversion de tension (3), la tension continue de sortie est générée à partir de la deuxième tension continue, un élément de commutation (23) d'au moins un transformateur élévateur (20) étant commuté avec un rapport cyclique ou taux d'impulsions régulé dans le deuxième étage de conversion de tension.

2. Procédé selon la revendication 1, **caractérisé en ce que** la deuxième tension continue est élevée dans le deuxième étage de conversion de tension (3).

3. Procédé selon la revendication 2, **caractérisé en ce que** la tension continue de sortie est générée à partir la deuxième tension continue en commutant de manière décalée dans le temps les éléments de commutation (33, 37) d'au moins deux transformateurs élévateurs avec un rapport cyclique régulé.

4. Procédé pour générer une tension continue de sortie d'une unité d'alimentation en tension d'un processus à décharge gazeuse, dans lequel une tension continue, en particulier plus élevée, est générée à partir d'une tension continue par au moins deux transformateurs élévateurs, en particulier couplés en parallèle, en commutant de manière décalée dans le temps les éléments de commutation (33, 37) des transformateurs élévateurs avec un rapport cyclique régulé.

5. Procédé selon l'une des revendications précédentes, **caractérisé en ce que** l'élément de commutation est commandé à une fréquence ≥ 18 kHz.

6. Procédé selon l'une des revendications 3 à 5, **caractérisé en ce que** les éléments de commutation (33, 37) sont commandés à la même fréquence ou par un multiple d'une fréquence fondamentale prédéfinie.

7. Procédé selon l'une des revendications 1 à 3 ou 5, 6, **caractérisé en ce que** la première tension continue est d'abord convertie en une tension alternative qui est ensuite redressée en la deuxième tension continue.

8. Procédé selon la revendication 7, **caractérisé en ce que** la tension alternative est générée par un circuit en pont d'éléments de commutation (12 à 15), les éléments de commutation (12 à 15) étant commandés par modulation de largeur d'impulsions ou déplacement de phase (phase shift).

9. Procédé selon la revendication 8, **caractérisé en ce que** les éléments de commutation (12 à 15) du circuit en pont et les éléments de commutation (23, 33, 37) du ou des transformateur(s) élévateur(s) (20) sont commandés à la même fréquence ou par un multiple d'une fréquence fondamentale prédéfinie.

10. Procédé selon la revendication 8 ou 9, **caractérisé en ce que** la tension alternative est transformée avant le redressement.

11. Procédé selon l'une des revendications précédentes, **caractérisé en ce que** la première tension continue est générée à partir d'une tension de secteur par redressement.

12. Procédé selon l'une des revendications précédentes, **caractérisé en ce que** la deuxième tension continue est générée avec une tension < 650 V, de préférence dans la plage de 50 à 650 V, à partir de la première tension continue, et la tension de sortie est générée avec une tension > 600 V, de préférence dans la plage de 600 à 2000 V, à partir de la deuxième tension continue.

13. Unité d'alimentation en tension continue d'un processus au plasma (1) pour réaliser le procédé selon l'une des revendications 1 à 12, avec un premier étage de conversion de tension (2) pour convertir une première tension continue en une deuxième tension continue et avec un deuxième étage de conversion de tension (3), le deuxième étage de conversion de tension (3) pour convertir la deuxième tension continue en une tension continue de sortie suivant le premier étage de conversion de tension (2) et présentant, pour générer la tension de sortie, au moins un transformateur élévateur (20) avec un élément de commutation (23) qui est commandé avec un rapport cyclique ou taux d'impulsions régulé.

14. Unité d'alimentation en tension continue d'un processus au plasma selon la revendication 13, **caractérisée en ce qu'**il est prévu une unité de commande (6) qui commande le premier et le deuxième étage de conversion de tension (2, 3).

15. Unité d'alimentation en tension continue d'un processus au plasma, en particulier selon la revendication 13 ou 14, **caractérisée en ce qu'**il est prévu au moins deux transformateurs élévateurs couplés en parallèle.

16. Unité d'alimentation en tension continue d'un processus au plasma selon la revendication 15, **caractérisée en ce que** les transformateurs élévateurs présentent un condensateur de filtrage (34) commun.

17. Unité d'alimentation en tension continue d'un processus au plasma selon l'une des revendications 15 ou 16, **caractérisée en ce que** les éléments de commutation (33, 37) des transformateurs élévateurs sont commandés de manière décalée dans le temps.

18. Unité d'alimentation en tension continue d'un processus au plasma selon l'une des revendications 13 à 17 précédentes, **caractérisée en ce que** le premier étage de conversion de tension (2) présente un onduleur (11) pour générer une tension alternative à partir de la première tension continue, un transformateur (16) qui y est relié pour transformer la tension de la tension alternative et un redresseur (19) pour générer la deuxième tension continue.

19. Unité d'alimentation en tension continue d'un processus au plasma selon la revendication 18, **caractérisée en ce que** l'onduleur (11) est réalisé sous forme de circuit en pont.
